# EUROPEAN PATENT APPLICATION

(11) **EP 4 694 633 A1**
(43) Date of publication of application: **11.02.2026**
(21) Application number: 24925597.7
(22) Date of filing: 26.11.2024
(51) Int. Cl.: H10K 30/40, H10K 30/88, H10K 71/00

(54) **PEROVSKITE SOLAR CELL ASSEMBLY PACKAGING STRUCTURE AND PACKAGING METHOD THEREOF**

(30) Priority: 19.02.2024 CN 202410183571
(71) Applicant: Xi'an TJ-Solar New Energy Co., Ltd, Xianyang, Shaanxi 712046 (CN)
(72) Inventor: ZHAO, Changzheng, Xianyang, Shaanxi 712046 (CN); LI, Peizhou, Xianyang, Shaanxi 712046 (CN)
(74) Representative: Novagraaf Technologies
(86) International application number: PCT/CN2024/134599
(87) International publication number: WO 2025/175859

(57) **Abstract**

The present disclosure belongs to the technical field of photovoltaic modules, and relates to an encapsulation structure of perovskite solar cell module and an encapsulation method of encapsulation structure of perovskite solar cell module. The encapsulation structure includes a transparent conductive substrate, a perovskite solar cell module and an encapsulation component, which are sequentially stacked; the encapsulation component includes an encapsulation layer and a glass cover plate disposed thereon; and the encapsulation layer has a structure in which at least one polyolefin thermoplastic elastomer layer and at least one inorganic layer are alternately stacked. The polyolefin thermoplastic elastomer layer and the inorganic layer have a better complementary effect and excellent adhesion property, so that a perovskite cell can be better encapsulated by the encapsulation component and thus has a very low water vapor transmission efficiency, thereby the corrosion of water and/or oxygen to the perovskite cell can be reduced; and meanwhile the perovskite cell has relatively high tolerance to potential-induced attenuation, and thus has a relatively long service life and relatively good stability, therefore the perovskite cell can be applied to a high-humidity environment such as sleep, seasides, ponds, etc.

## Description

### Technical Field

The present disclosure belongs to the technical field of photovoltaic modules, and relates to an encapsulation structure of perovskite solar cell module and an encapsulation method of encapsulation structure of perovskite solar cell module.

### Background

A perovskite solar cell is a solar cell using a perovskite organic metal halide semiconductor material as a light absorption material, is mainly composed of a transparent conductive layer, a hole transport layer, a perovskite absorber layer, an electron transport layer and a back electrode , and has the advantages of high photoelectric conversion efficiency and low production cost as a novel solar cell.

However, during the process of contacting with the air, a perovskite material is decomposed due to the influence of moisture and oxygen in the air, thereby greatly reducing the photoelectric conversion efficiency of the perovskite solar cell. Therefore, the perovskite solar cell needs to be encapsulated before actual use, but the encapsulation technology cannot meet the requirements of the perovskite solar cell in terms of waterproofness, and a high-temperature operation is often required in an encapsulation process, which will inevitably affect the performance of the perovskite solar cell, and thus higher technical requirements are undoubtedly proposed for the module encapsulation technology.

In view of this, the present disclosure is proposed.

### Summary

The objective of the present disclosure is to overcome the above shortcomings of the prior art, and to provide an encapsulation structure of perovskite solar cell module and an encapsulation method of encapsulation structure of perovskite solar cell module, so as to enhance the moisture and/or oxygen barrier property of a perovskite solar cell, thereby prolonging the lifespan of the perovskitecell.

To achieve the above objective, the present disclosure provides the following technical solutions:
In one aspect, the present disclosure provides an encapsulation structure of perovskite solar cell module, including a transparent conductive substrate, a perovskite solar cell module and an encapsulation component, which are sequentially stacked from bottom to top, wherein
the encapsulation component includes an encapsulation layer and a glass cover plate located above the encapsulation layer, and the encapsulation layer has a structure in which at least one polyolefin thermoplastic elastomer layer and at least one inorganic layer are alternately stacked.

In some embodiments, the polyolefin thermoplastic elastomer layer includes at least one of an ethylene-vinyl acetate (EVA) copolymer layer, a polyolefin elastomer (POE) layer, a co-extruded POE encapsulation film (EPE) layer, and a polyvinyl butyral (PVB) layer, and preferably includes a POE layer, so as to improve the adhesion property of the polyolefin thermoplastic elastomer layer to the inorganic layer and the perovskite solar cell module.

In some embodiments, the POE layer is composed of a first POE layer and a second POE layer, the inorganic layer is a first inorganic layer, the encapsulation layer utilizes a structure of "the first POE layer-the first inorganic layer-the second POE layer", and the positions of the first POE layer and the second POE layer are exchanged;
or, the inorganic layer is composed of a first inorganic layer and a second inorganic layer, the POE layer is a first POE layer, the encapsulation layer utilizes a structure of "the first inorganic layer-the POE layer-the second inorganic layer ", and the positions of the first inorganic layer and the second inorganic layer are exchanged.

In some embodiments, the POE layer is a copolymer of ethylene and octene, and the degree of polymerization of the POE layer is 2500-4000, so that the capability of the POE layer for the inorganic layer during a preparation process can be effectively improved.

In some embodiments, the inorganic layer has the effect of supplementing the POE layer, and the inorganic layer is prepared from an inorganic material having excellent light transmittance and moisture and/or oxygen barrier property, and the inorganic layer includes a metal, a non-metal, a compound or alloy of at least two metals, a compound or alloy of at least two non-metals, a metal or non-metal oxide, a metal or non-metal fluoride, a metal or non-metal nitride, a metal or non-metal carbide, a metal or non-metal oxynitride, a metal or non-metal boride, a metal or non-metal oxyboride, a metal or non-metal silicide, or a mixture thereof. The metal includes aluminum (Al), zinc (Zn), antimony (Sb), indium (In), germanium (Ge), tin (Sn), bismuth (Bi), transition metals, and lanthanide metals, but is not limited thereto; and the non-metal includes silicon (Si), selenium (Se), and the like, but is not limited thereto. Specifically, the inorganic layer includes silicon oxide (SiOₓ), silicon nitride (SiNₓ), silicon oxynitride (SiOₓN_{y}), zinc selenide (ZnSe), zinc oxide (ZnO), antimony trioxide (Sb₂O₃), aluminum oxide (AlOₓ), indium oxide (In₂O₃), or tin oxide (SnO₂).

In some embodiments, the inorganic layer is deposited by a plasma process or vacuum process, for example, sputtering, chemical vapor deposition (CVD), plasma enhanced chemical vapor deposition (PECVD), evaporation, sublimation, electron cyclotron resonance-plasma enhanced chemical vapor deposition (ECR-PECVD), and combinations thereof.

In some embodiments, the thickness of the inorganic layer is 5 nm to 10 µm; and the thickness of the POE layer is 5 µm to 100 µm. Within this thickness range, both the inorganic layer and the POE layer have a better complementary effect, and the POE layer has higher uniformity, has better coverage for the perovskite solar cell, better achieves a water vapor barrier effect, and meanwhile better buffers a stress, thereby having a positive effect of improving the stability of the perovskite solar cell.

It should be noted that the thickness of the POE layer is adaptively prepared according to actual encapsulation requirements, optional thicknesses is 5 µm, 10 µm, 25 µm, 35 µm, 45 µm, 55 µm, 65 µm, 75 µm, 85 µm, 95 µm, 100 µm, and the like, which are not listed one by one; and the thickness of the inorganic layer is adaptively prepared according to actual encapsulation requirements, optional thicknesses is 5 nm, 20 nm, 40 nm, 80 nm, 100 nm, 300 nm, 500 nm, 700 nm, 900 nm, 1000 nm, 2 µm, 4 µm, 6 µm, 8 µm, 10 µm, and the like, which are not listed one by one.

In some embodiments, the glass cover plate is made of a transparent glass material; and specifically, any one of ultra-white low-iron tempered glass, low-iron patterned tempered glass, semi-tempered glass, coated glass, TPT glass, TPE glass and PET glass is selected.

In some embodiments, the encapsulation method of the encapsulation component is lamination, the temperature of the lamination is 100 °C to 140 °C, and the lamination time is 5 min to 40 min; and when the temperature and the lamination time are within the above numerical ranges, the inorganic layer and the POE layer are good in uniformly and high in water vapor barrier efficiency, and the perovskite solar cell module has good stability after being encapsulated.

In some embodiments, the encapsulation component further includes an encapsulant, and the encapsulant is a PIB encapsulant; and the thickness of the encapsulant is 0.2 mm to 1.5 mm, the thickness of the encapsulant is adaptively prepared according to actual encapsulation requirements, optional thicknesses is 0.3 mm, 0.4 mm, 0.5 mm, 0.6 mm, 0.7 mm, 0.8 mm, 0.9 mm, 1.0 mm, 1.1 mm, 1.2 mm, 1.3 mm, 1.4 mm, and the like, which are not listed one by one.

In another aspect, the present disclosure further provides an encapsulation method of an encapsulation structure of perovskite solar cell module, wherein the specific steps are as follows:
Step 1: laying a POE membrane on the surface of a perovskite solar cell module to form a first POE layer;
step 2: coating an inorganic layer material on the surface of the first POE layer to form an inorganic layer;
step 3: laying a POE membrane on the surface of the inorganic layer to form a second POE layer;
step 4: attaching an encapsulant to the periphery of a glass cover plate, and then covering the glass cover plate above the second POE layer to obtain an encapsulation component; and
step 5: placing the encapsulation component into a laminating machine for lamination encapsulation, so as to obtain an encapsulation structure of perovskite solar cell module.

Materials and thicknesses of the first POE layer and the second POE layer are the same or different, and a size of the second POE layer cannot exceed the encapsulant on the periphery of the glass cover plate, or otherwise, there is a gap in the encapsulation.

In some embodiments, when the encapsulation component is placed in the laminating machine for lamination encapsulation, the specific process is as follows:
first performing vacuumizing and gas filling, and then performing air extraction and gas filling for multiple times.

In some embodiments, an edge of the glass cover plate is greater than an edge of the encapsulant.

In some embodiments, the perovskite solar cell module includes a conductive substrate, an electron transport layer, a perovskite absorber layer, a hole transport layer and a metal electrode.

The electron transport layer, the perovskite absorber layer, the hole transport layer and the metal electrode are formed on the conductive substrate layer by layer, for example, the perovskite solar cell module of the present disclosure is formed by stacking from bottom to top in a sequence of "the conductive substrate-the electron transport layer-the perovskite absorber layer-the hole transport layer-the metal electrode"; or, the perovskite solar cell module of the present disclosure is formed by stacking from bottom to top in a sequence of "the conductive substrate-the hole transport layer-the perovskite absorber layer-the electron transport layer-the metal electrode".

It should be noted that:
The conductive substrate is not particularly limited in the present disclosure, any conductive substrate known in the art is used as long as the objective of the present disclosure is achieved. For example, the conductive substrate includes a flexible conductive substrate or a conductive glass substrate, wherein the flexible conductive substrate is a fluorine-doped tin oxide (FTO) flexible conductive substrate or an indium-doped tin oxide (ITO) flexible conductive substrate; and the conductive glass substrate is a rigid transparent substrate, for example, an FTO conductive glass substrate or an ITO conductive glass substrate.

The material of the electron transport layer is not particularly limited in the present disclosure, and may be materials known to those skilled in the art or a combination thereof, for example, the electron transport layer is selected from a titanium dioxide (TiO₂) electron transport layer, a stannic dioxide (SnO₂) electron transport layer, or a zinc oxide (ZnO) electron transport layer, and the like; and moreover, the thickness of the electron transport layer is not particularly limited in the present disclosure, as long as the objective of the present disclosure is achieved, for example, a thickness of the electron transport layer is 20 nm to 100 nm. The preparation process of the electron transport layer is not particularly limited in the present disclosure, for example, a solution spin-coating method, a solution scrape-coating method, a solution spray-coating method, a slot-die coating method, or a hydrothermal growth method or the like is used. In some embodiments of the present disclosure, the preparation method of the electron transport layer is the slot-die coating method.

The hole transport layer is not particularly limited in the present disclosure, and materials known to those skilled in the art or a combination thereof, for example, any one of stratified structures prepared from nickel oxide, doped nickel oxide, cuprous iodide, cuprous thiocyanate, poly[bis (4-phenyl) (2, 4, 6-trimethylphenyl) amine] (PTAA), PEDOT: PSS, or Spiro-OMeTAD; moreover, the thickness of the hole transport layer is not particularly limited in the present disclosure, as long as the objective of the present disclosure is achieved, for example, a thickness of the hole transport layer may be 10 nm to 100 nm; and the preparation process of the hole transport layer is not particularly limited in the present disclosure, for example, a solution spin-coating method, a solution scrape-coating method, a slot-die coating method, or a vapor phase method or the like is used. In some embodiments of the present disclosure, the preparation method of the hole transport layer is the slot-die coating method.

The perovskite absorber layer is not particularly limited in the present disclosure, and may be materials known to those skilled in the art or a combination thereof, for example, the perovskite absorber layer includes a perovskite material having an ABO₃ type structure, and the perovskite material is selected from any of CH₃NH₃PbBr₃, CH₃NH₃Pbl₃, CH₃NH₃Pbl₂Cl, and CH₃NH₃Pb(I₁₋ₓBrₓ)₃, wherein 0 ≤ x ≤ 1. The preparation process of the perovskite absorber layer is not particularly limited in the present disclosure, for example, a solution spin-coating method, a solution scrape-coating method, a slot-die coating method, or a steam method, and the like. In some embodiments of the present disclosure, the preparation method of the perovskite absorber layer is the slot-die coating method.

The material of the metal electrode is not particularly limited in the present disclosure, and may be materials known to those skilled in the art or a combination thereof, for example, the metal electrode is any of a gold (Au) electrode, a silver (Ag) electrode, an aluminum (Al) electrode, or a copper (Cu) electrode; and moreover, the thickness of the metal electrode is not particularly limited in the present disclosure, as long as the objective of the present disclosure is achieved, for example, a thickness of the metal electrode is 50 nm to 100 nm, and a better effect is obtained within the thickness range of the electrode. Of course, those skilled in the art may select an appropriate thickness of the metal electrode as needed. The preparation process of the metal electrode is not particularly limited in the present disclosure, for example, a thermal evaporation method is used.

According to requirements, the perovskite solar cell of the present disclosure further includes other layers, for example, a passivation layer.

Compared with the art known to inventors, the technical solutions provided in the present disclosure includes the following beneficial effects:
The encapsulation layer of the present disclosure utilizes the structure in which at least one polyolefin thermoplastic elastomer layer and at least one inorganic layer are alternately stacked, wherein the polyolefin thermoplastic elastomer layer and the inorganic layer have a better complementary effect and excellent adhesion property, so that the perovskite cell can be better encapsulated by the encapsulation structure and thus has a very low water vapor transmission efficiency, thereby the corrosion of water and/or oxygen to the perovskite cell can be reduced; and meanwhile the perovskite cell has relatively high tolerance to potential-induced attenuation, and thus has a relatively long lifespan and relatively good stability, therefore the perovskite cell can be applied to a high-humidity environment such as water surface, seasides, ponds, etc.

### Brief Description of the Drawings

The drawings herein are incorporated into and constitute a part of the present specification, and serve to explain the principles of the present disclosure together with the specification.

To illustrate technical solutions in the embodiments of the present disclosure or in the prior art more clearly, a brief introduction on the drawings which are needed in the description of the embodiments or the prior art is given below. Apparently, for those ordinary skilled in the art, other drawings may also be obtained according to these drawings without any creative effort.
Fig. 1 illustrates a diagram of an encapsulation structure of perovskite solar cell module provided in Embodiment 1 of the present disclosure;
Fig. 2 illustrates a diagram of an encapsulation structure of perovskite solar cell module provided in Embodiment 2 of the present disclosure;
Fig. 3 illustrates a diagram of an encapsulation structure of perovskite solar cell module provided in Embodiment 3 of the present disclosure; and
Fig. 4 illustrates time-varying change curves of normalization efficiency of encapsulation structure of perovskite solar cell modules provided in Embodiments 1-4 and Comparative Example 1.

Wherein: 10. transparent conductive substrate; 20. perovskite solar cell module; 30. encapsulation component; 31. first POE layer; 32. first inorganic layer; 33. second POE layer; 34. encapsulant; 35. glass cover plate; 36. second inorganic layer.

### Detailed Description of the Embodiments

Exemplary embodiments will be described herein in detail, and examples of which are illustrated in the drawings. When the following description involves the drawings, unless otherwise represented, the same numbers in different drawings represent the same or similar elements. The implementations set forth in the following exemplary embodiments do not represent all implementations consistent with the present disclosure. Instead, they are merely examples consistent with some aspects of the present disclosure as detailed in the appended claims.

An encapsulation structure of perovskite solar cell module provided in an embodiment of the present disclosure includes a transparent conductive substrate 10, a perovskite solar cell module 20 and an encapsulation component 30, which are sequentially stacked; and
the encapsulation component 30 includes an encapsulation layer and a glass cover plate 35; and the encapsulation layer has a structure in which at least one polyolefin thermoplastic elastomer layer and at least one inorganic layer are alternately stacked.

In the embodiment, the inorganic layer is at least one of a metal, a metal oxide, a metal fluoride, a metal nitride, a metal oxynitride, a metal boride, a metal oxygen boride or a metal silicide. The metal may include at least one selected from aluminum, zinc, antimony, indium, germanium, tin, bismuth, transition metals, and lanthanide metals.

In the embodiment, the non-metal includes silicon, selenium and other non-metals.

In some embodiments, the encapsulation component 30 further includes an encapsulant 34. In the embodiment, the encapsulant 34 is a PIB encapsulant; and the thickness of the encapsulant 34 is 0.2 mm to 1.5 mm.

The encapsulation method of the encapsulation structure of perovskite solar cell module provided in the present disclosure is specifically as follows: firstly, preparing the encapsulation layer on the surface of the perovskite solar cell module 20 in such a manner that "the polyolefin thermoplastic elastomer layer and the inorganic layer are alternately stacked"; then, covering the glass cover plate 35 above the encapsulation layer to obtain the encapsulation component 30; and finally, placing the encapsulation component 30 into a laminating machine for lamination encapsulation.

In order to enable those skilled in the art to better understand the technical solutions of the present disclosure, the present disclosure will be further described in detail below with reference to the drawings and embodiments.

### Embodiment 1

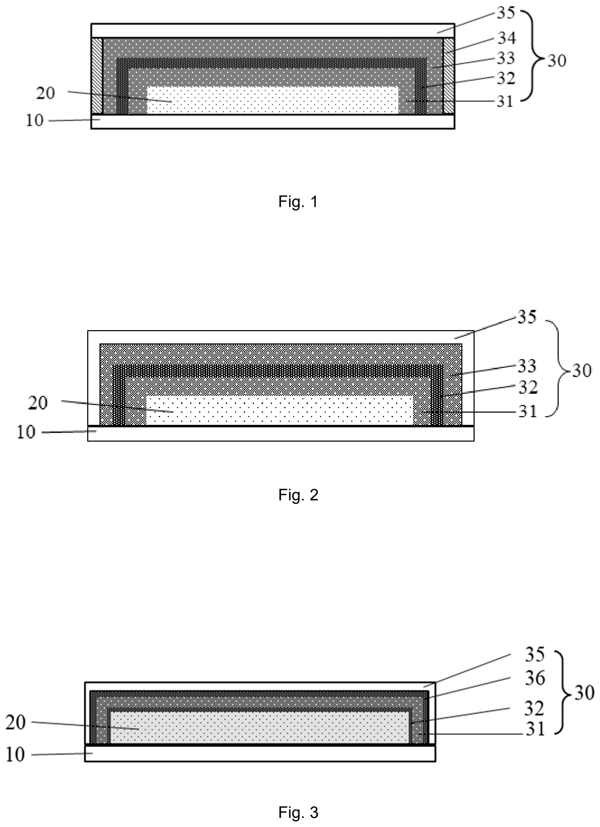

The encapsulation structure of perovskite solar cell module provided in the present embodiment includes a transparent conductive substrate, a perovskite solar cell module and an encapsulation component, which are sequentially stacked;
the encapsulation component includes an encapsulation layer and a glass cover plate; as shown in Fig. 1, the encapsulation layer utilizes a structure of "a first POE layer 31-a first inorganic layer 32-a second POE layer 33", the first POE layer 31 and the second POE layer 33 are made of the same material and are both made of pure POE-P507 of Shanghai HIUV New Material Co., Ltd, a thickness of the first POE layer 31 is 51 µm, and a thickness of the second POE layer 33 is 38 µm; and a material of the first inorganic layer 32 is silicon nitride, and a thickness of the first inorganic layer 32 is 500 nm.

The preparation process of the encapsulation component 30 is specifically as follows:
first, laying the first POE layer 31 (membrane) on the surface of the perovskite solar cell module 20, then coating the material of the first inorganic layer 32 on the surface of the first POE layer 31 in a PECVD (plasma enhanced chemical vapor deposition) manner, next, laying the second POE layer 33 on the surface of the first inorganic layer 32, attaching the PIB encapsulant (having a thickness of 0.5 mm) to the periphery of the glass cover plate 35, and then covering the second POE layer 35 to obtain a component to be encapsulated; and
then, placing the component to be encapsulated into a laminating machine, providing separator fabric above and below the component to be encapsulated, so that the component to be encapsulated is not in direct contact with the laminating machine, setting a lamination temperature to be 120 °C, and setting a lamination time to be 10 min, wherein a specific lamination process is: first performing vacuumizing for 300 s, then inflating the upper chamber and performing first-time gas filling, performing first-time air extraction for 10 s, and then performing gas filling; performing second-time air extraction for 10 s, and then performing gas filling; performing third-time air extraction for 300 s, and then performing gas filling; and taking out the encapsulated encapsulation component, placing the same for cooling to complete the preparation of the encapsulation component 30.

The perovskite solar cell module 20 includes a transparent conductive substrate 10, an electron transport layer, a perovskite absorber layer, a hole transport layer and a metal electrode layer, the conductive substrate herein is an ITO conductive glass substrate, and the preparation processes of the layers are specifically as follows:

### <Preparation of the conductive substrate>

Performing ultrasonic cleaning sequentially on the ITO conductive glass substrate by using an ITO cleaning agent, water, a mixed solution of ethanol and acetone (Vₑₜₕₐₙₒₗ: V_{acetone} = 1: 1) and water, drying the ITO conductive glass substrate by using a nitrogen gun, and then performing a UV-ozone treatment for 10 min.

### <Preparation of the electron transport layer>

Preparing an ethanol solution of mesoporous titanium dioxide (a mass fraction ratio of titanium dioxide slurry to ethanol is 1: 5), performing an ultrasonic treatment for 30 min to obtain a precursor solution, spin coating 100 µL of the precursor solution on the surface of the ITO conductive glass substrate, then transferring the ITO conductive glass substrate into an oven to be heated for 30 min at a temperature of 70 °C, then performing annealing at a temperature of 180 °C for 30 min, and naturally cooling to the room temperature to obtain the electron transport layer.

### <Preparation of the perovskite absorber layer>

Dissolving 760.65 mg of lead iodide (PbI₂), 246.9 mg of form amidinium iodide (FAI), 12.5 mg of methyl ammonium bromide (MABr), 18.72 mg of cesium iodide and 21.95 mg of methylamine hydrochloride in 1 ml of mixed solution of dimethyl formamide and dimethyl sulfoxide (V_{dimethyl formamide} : V_{dimethyl sulfoxide} = 4: 1), stirring for 3 h to prepare a perovskite precursor solution, then spin coating the perovskite precursor solution on a titanium dioxide electron transport layer at a spin coating speed of 2000 rpm and for a spin coating time of 10 s, dripping 250 µL of chlorobenzene as an anti-solvent before the end of spin coating, then performing pre-annealing at a temperature of 100 °C for 10 min, and performing annealing at a temperature of 150 °C for 15 min; and spin coating 250 µL of phenyl propyl ammonium Iodide (PPAI) as a passivation layer at a spin coating speed of 5000 rpm and for a spin coating time of 30 s, and performing curing to form a thin film to complete the preparation of the perovskite absorber layer.

### <Preparation of the hole transport layer>

Adding 90 mg of Spiro-OMeTAD, 28.5 µL of tributyl phosphate, 17.8 µL of mixed solution of lithium bis ((trifluoromethyl) sulfonyl) azanide and acetonitrile (520 mg/mL of lithium bis ((trifluoromethyl) sulfonyl) azanide is dissolved in acetonitrile), and 20 µL of mixed solution of FK209 and acetonitrile (200 mg/mL of MPTFK 209 is dissolved in acetonitrile) into 1 mL of chlorobenzene, stirring for 5 h to prepare a Spiro-OMeTAD precursor solution, then spin coating 28 µL of the prepared Spiro-OMeTAD precursor solution on the passivation layer (PPAI) at a spin coating speed of 3000 rpm and for a spin coating time of 30 s, so as to obtain the hole transport layer without performing annealing.

### <Preparation of the metal electrode layer>

Depositing an Au electrode on the hole transport layer by using a thermal evaporation method at an evaporation current of 120 A, first evaporating to 10 nm at a rate of 0.1 Å/s, and then evaporating to 40 nm at 0.5 Å/s with a thickness of 50 nm.

### Embodiment 2

On the basis of Embodiment 1, the difference from Embodiment 1 lies that the glass cover plate 35 utilizes a groove-shaped structure, and the encapsulation component 30 do not include the encapsulant 34, as shown in Fig. 2, and the encapsulation of the encapsulation structure of perovskite solar cell module is completed.

### Embodiment 3

On the basis of Embodiment 1, the difference from Embodiment 1 lies that the encapsulation layer utilizes a structure of "a first inorganic layer 32-the first POE layer 31-a second inorganic layer 36", the glass cover plate 35 utilizes a groove-shaped structure, and the encapsulation component 30 does not include the encapsulant 34, as shown in Fig. 3; and the thickness of the first inorganic layer 32 is 5 nm, and the thickness of the second inorganic layer 36 is 10 µm.

The first inorganic layer 32 and the second inorganic layer 36 are made of silicon nitride, and prepared by using a chemical vapor deposition (CVD) preparation process.

### Embodiment 4

On the basis of Embodiment 1, the difference from Embodiment 1 lies that in the preparation of the encapsulation component 30, the first inorganic layer 32 is made of silicon oxynitride.

### Embodiment 5

On the basis of Embodiment 1, the difference from Embodiment 1 lies that in the preparation of the encapsulation component 30, the first POE layer 31 and the second POE layer 33 are made of the same material and are both made of KT-606P of the Baixing Group Co., Ltd, the thickness of the first POE layer 31 is 30 µm, and the thickness of the second layer POE layer 33 is 70 µm; and the lamination temperature is set to be 140 °C, and the lamination time is 5 min.

### Embodiment 6

On the basis of Embodiment 1, the difference from Embodiment 1 lies that in the preparation of the encapsulation component 30, the first POE layer 31 and the second POE layer 33 are made of the same material and are both made of KT-606P of the Baixing Group Co., Ltd, the thickness of the first POE layer 31 is 80 µm, and the thickness of the second POE layer 33 are 25 µm; and the lamination temperature is set to be 100 °C, and the lamination time is 35 min.

### Comparative Example 1

For the encapsulation structure in Comparative Example 1, there is only one POE layer, and the thickness of the POE layer is 89 µm; the rest is the same as that in Embodiment 1.

### Performance Test

In order to verify the effectiveness of the technical solutions provided in the present disclosure, a standard performance test is performed on the encapsulation structure of perovskite solar cell modules disclosed in Embodiments 1-4 and the encapsulation structure of perovskite solar cell module provided in Comparative Example 1, and the specific test process is as follows:
Drawing a PCE-t curve (a time-varying change curve of normalization efficiency), and using a sunlight simulator for measurement, wherein the light intensity of the sunlight simulator is 100 mA/cm², the experiment condition is illumination at an atmospheric pressure, the temperature is 20 °C, and the humidity is 30%.

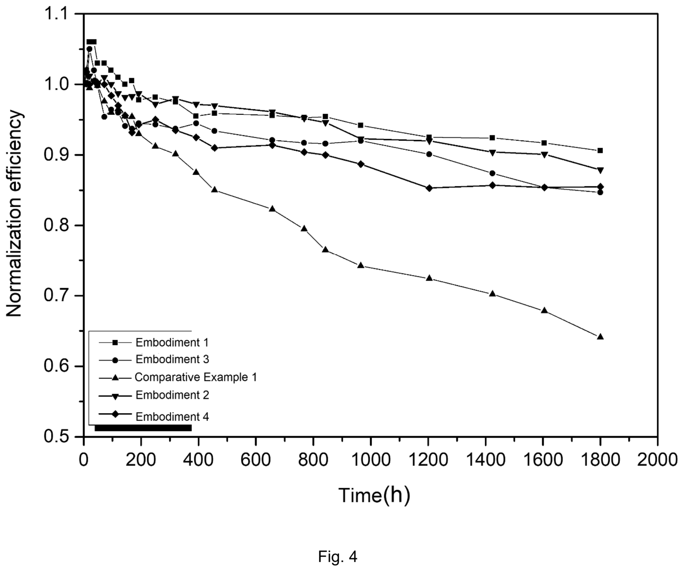

Fig. 4 illustrates time-varying change curves of normalization efficiency of the encapsulation structure of perovskite solar cell modules provided in Embodiments 1-4 and Comparative Example 1. It can be seen from Fig. 4 that after 1800 h, the normalization efficiency of the encapsulation structure of perovskite solar cell module provided in Comparative Example 1 only maintains about 65% of the initial efficiency thereof, the encapsulation structure of perovskite solar cell modules provided in Embodiment 3 and Embodiment 4 are maintain more than 85% of the initial efficiency thereof, and the encapsulation structure of perovskite solar cell modules provided in Embodiment 1 and Embodiment 2 are still maintain more than 90% of the initial efficiency thereof. Therefore, over time, the normalization efficiency of the encapsulation structure of perovskite solar cell modules provided in Embodiments 1-4 is better than the normalization efficiency of the encapsulation structure of perovskite solar cell module provided in Comparative Example 1.

The above descriptions are only specific implementations of the present disclosure, so that those skilled in the art can understand or implement the present disclosure. Various modifications to these embodiments will be readily apparent to those skilled in the art, and the generic principles defined herein may be implemented in other embodiments without departing from the spirit or scope of the present disclosure.

It should be understood that the present disclosure is not limited to what has been described above, and that various modifications and changes may be made without departing from the scope thereof. The scope of the present disclosure is only limited by the appended claims.

## Claims

1. An encapsulation structure of perovskite solar cell module, comprising a transparent conductive substrate (10), a perovskite solar cell module (20) and an encapsulation component, which are sequentially stacked, wherein
the encapsulation component comprises an encapsulation layer and a glass cover plate, and the encapsulation layer has a structure in which at least one polyolefin thermoplastic elastomer layer and at least one inorganic layer are alternately stacked.

2. The encapsulation structure of perovskite solar cell module according to claim 1, wherein the polyolefin thermoplastic elastomer layer comprises at least one of an ethylene-vinyl acetate copolymer layer, a polyolefin elastomer layer, a co-extruded POE encapsulation film layer, and a polyvinyl butyral layer.

3. The encapsulation structure of perovskite solar cell module according to claim 2, wherein the polyolefin elastomer layer is a copolymer of ethylene and octene.

4. The encapsulation structure of perovskite solar cell module according to claim 3, wherein a degree of polymerization of the copolymer of ethylene and octene is 2500-4000.

5. The encapsulation structure of perovskite solar cell module according to claim 1, wherein the inorganic layer comprises at least one of the following substances:
a metal, a non-metal, a compound or alloy of at least two metals, a compound or alloy of at least two non-metals, a metal or non-metal oxide, a metal or non-metal fluoride, a metal or non-metal nitride, a metal or non-metal carbide, a metal or non-metal oxynitride, a metal or non-metal boride, a metal or non-metal oxyboride, and a metal or non-metal silicide.

6. The encapsulation structure of perovskite solar cell module according to claim 1, wherein a thickness of the inorganic layer is 5 nm to 10 µm.

7. The encapsulation structure of perovskite solar cell module according to claim 1, wherein a thickness of the polyolefin thermoplastic elastomer layer is 5 µm to 100 µm.

8. The encapsulation structure of perovskite solar cell module according to claim 1, wherein an encapsulation method of the encapsulation component (30) is lamination, a temperature of the lamination is 100 °C to 140 °C, and the lamination time is 5 min to 40 min.

9. The encapsulation structure of perovskite solar cell module according to claim 1, wherein the encapsulation component further comprises an encapsulant.

10. An encapsulation method of the encapsulation structure of perovskite solar cell module according to any of claims 1-9, wherein steps are specific as follows: firstly, preparing the encapsulation layer on a surface of the perovskite solar cell module (20) in such a manner that "a polyolefin thermoplastic elastomer layer and an inorganic layer are alternately stacked"; then, covering the glass cover plate (35) above the encapsulation layer to obtain the encapsulation component (30); and finally, placing the encapsulation component (30) into a laminating machine for lamination encapsulation.
